# EUROPEAN PATENT APPLICATION

(11) **EP 4 723 851 A1**
(43) Date of publication of application: **08.04.2026**
(21) Application number: 24813987.5
(22) Date of filing: 17.04.2024
(51) Int. Cl.: H10K 59/126

(54) **DISPLAY PANEL AND DISPLAY APPARATUS**

(30) Priority: 26.05.2023 CN 202310613197
(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: HU, Wenbo, Beijing 100176 (CN); LI, Xudong, Beijing 100176 (CN); ZHANG, Jing, Beijing 100176 (CN); MU, Zenan, Beijing 100176 (CN); XUE, Xinghao, Beijing 100176 (CN); XIAN, Jianbo, Beijing 100176 (CN)
(74) Representative: Potter Clarkson
(86) International application number: PCT/CN2024/088396
(87) International publication number: WO 2024/244781

(57) **Abstract**

The present disclosure relates to a display panel. The display panel comprises a partition unit. An encapsulation layer is arranged on the side, away from a substrate, of the partition unit. The encapsulation layer comprises a first connecting part. A first blocking part is arranged on the side, away from the substrate, of the encapsulation layer, and in the width direction of the first blocking part, the orthographic projection of the first blocking part on the encapsulation layer covers the first connecting part, so as to prevent water vapor from entering from the covered position of the first connecting part. The path of water and oxygen invading from the first connecting part can be blocked and prolonged, corrosion of a light-emitting material layer is slowed down or prevented, the encapsulation effect of the display panel is improved, and normal display of the display panel is guaranteed. The present disclosure further provides a display apparatus comprising the display panel.

## Description

### CROSS REFERENCE

The present disclosure claims priority to Chinese patent application No. 202310613197.5 filed on May 26, 2023, entitled "Display Panel and Display device", the entire contents of which are incorporated herein by reference.

### TECHNICAL FIELD

The present disclosure relates to the field of display technology, and in particular to a display panel and a display device.

### BACKGROUND

In order to enhance user experience, display devices are developing in the direction of full screen. The perforated screen is a trend in the development of full screen, which is a technology that provides opening(s) on the display panel to increase the screen-to-body ratio.

For display panels with opening(s), cracks are likely to appear in the encapsulation layer around the openings, and the cracks become the intrusion paths for water and oxygen. After the intrusion of water and oxygen, the luminescent material layer will be corroded and fail, affecting normal display.

It should be noted that the information disclosed in the above background section is only used to enhance understanding the background of the present disclosure, and therefore may include information that does not constitute the prior art known to those skilled in the art.

### SUMMARY

The purpose of the present disclosure is to provide a display panel and a display device, so as to overcome the problem that cracks around openings in the encapsulation layer are easily invaded by water and oxygen.

According to an aspect of this disclosure, a display panel is provided and has a main region, where the main region includes an opening area, a display area and a transition area connecting the display area and the opening area, the opening area is provided with an opening, and the display panel includes: a substrate, at least one partition unit, an encapsulation layer, and a first barrier layer. The at least one partition unit is provided on a side of the substrate and located in the transition area, where the partition unit surrounds the opening, the partition unit includes at least one partition structure, the partition structure includes two partition layers, and a width of a partition layer away from the substrate is greater than a width of a partition layer close to the substrate. The encapsulation layer includes a first encapsulation portion, a second encapsulation portion and a first connection portion, where the first encapsulation portion is provided on a side of the partition unit away from the substrate, the second encapsulation portion is provided between two adjacent partition units, the first connection portion is connected between the first encapsulation portion and the second encapsulation portion, and a distance between the substrate and a surface of the first encapsulation portion away from the substrate is greater than a distance between the substrate and a surface of the second encapsulation portion away from the substrate. The first barrier layer is provided on a side of the encapsulation layer away from the substrate, where the first barrier layer includes at least one first barrier portion; and in a width direction of the first barrier portion, an orthographic projection of the first barrier portion on the encapsulation layer covers the first connection portion.

In an embodiment of this disclosure, the at least one first barrier portion includes at least two discontinuous first barrier portions, the discontinuous first barrier portions are provided with discontinuities, and the discontinuities of two adjacent discontinuous first barrier portions are staggered with each other along an extension direction of the partition unit.

In an embodiment of this disclosure, the at least one first barrier portion includes at least two closed first barrier portions, the closed first barrier portion is provided as a continuous whole, and an orthographic projection of the closed first barrier portion on the substrate covers an orthographic projection of the partition unit on the substrate.

In an embodiment of this disclosure, the display panel further includes a barrier dam, where the barrier dam is provided on a side of the substrate and located in the transition area; the encapsulation layer further includes a third encapsulation portion and a third connection portion, the third encapsulation portion is provided on a side of the barrier dam away from the substrate, the third connection portion is connected between the third encapsulation portion and the second encapsulation portion; the display panel further includes a second barrier layer, and in a width direction of the second barrier layer, an orthographic projection of the second barrier layer on the encapsulation layer covers the third connection portion.

In an embodiment of this disclosure, the display panel further includes a barrier dam, where the barrier dam is provided on a side of the substrate and located in the transition area; the transition area includes a first transition sub-area and a second transition sub-area, the first transition sub-area is located between an edge of the barrier dam and an edge of the opening, and the second transition sub-area is located between the edge of the barrier dam and an edge of the display area; the first transition sub-area is provided with at least one partition unit, and the second transition sub-area is provided with at least one partition unit; the first barrier portion includes a first barrier sub-portion and a second barrier sub-portion, an orthographic projection of the first barrier sub-portion on the encapsulation layer covers a part of the second encapsulation portion and the first encapsulation portion in the first transition sub-area, and an orthographic projection of the second barrier sub-portion on the encapsulation layer covers a part of the second encapsulation portion and the first encapsulation portion in the second transition sub-area.

In an embodiment of this disclosure, the partition unit, the first barrier layer and the second barrier layer all have an inner contour and an outer contour, a shape of the inner contour of the partition unit and/or the outer contour of the partition unit, a shape of the inner contour of the first barrier layer and/or the outer contour of the first barrier layer, and a shape of the inner contour of the second barrier layer and/or the outer contour of the second barrier layer are all similar to a shape of the opening.

In an embodiment of this disclosure, the first transition sub-area and the second transition sub-area are each provided with at least two partition units, the first transition sub-area is provided with at least two first barrier sub-portions provided at an interval, and the second transition sub-area is provided with at least two second barrier sub-portions provided at an interval.

In an embodiment of this disclosure, the first barrier layer further includes at least one closed first barrier portion, the closed first barrier portion is provided as a continuous whole, and an orthographic projection of the closed first barrier portion on the substrate covers an orthographic projection of the partition unit on the substrate.

In an embodiment of this disclosure, the first barrier layer includes a plurality of discontinuous first barrier portions and a plurality of closed first barrier portions, and the plurality of closed first barrier portions and the plurality of discontinuous first barrier portions are alternately arranged in sequence along an extension direction away from an edge of the opening.

In an embodiment of this disclosure, the at least one first barrier portion includes at least one closed first barrier portion and at least two discontinuous first barrier portions, the closed first barrier portion is provided as a continuous whole, an orthographic projection of the closed first barrier portion on the substrate covers an orthographic projection of the partition unit on the substrate; the discontinuous first barrier portions are provided with discontinuities, and at least part of the discontinuities are located on a same straight line along a direction perpendicular to a width of the partition unit.

In an embodiment of this disclosure, a first barrier segment is formed between two adjacent discontinuities of one discontinuous first barrier portion, and lengths of first barrier segments of different discontinuous first barrier portions gradually increase in a direction away from the opening.

In an embodiment of this disclosure, the first barrier sub-portion includes a discontinuous first barrier sub-portion, the second barrier sub-portion includes a discontinuous second barrier sub-portion, and a length of a discontinuity of the discontinuous first barrier sub-portion is smaller than a length of a discontinuity of the discontinuous second barrier sub-portion.

In an embodiment of this disclosure, a distance between adjacent second barrier sub-portions is smaller than a distance between adjacent first barrier sub-portions.

In an embodiment of this disclosure, a ratio of a width of the second barrier sub-portion to a width of the partition unit is greater than a ratio of a width of the first barrier sub-portion to the width of the partition unit.

In an embodiment of this disclosure, the first barrier sub-portion and the second barrier sub-portion are attached to a side of the encapsulation layer away from the substrate, and an arrangement track of at least part of the second barrier sub-portion is gradually bent toward the substrate along a direction close to the opening.

In an embodiment of this disclosure, the second barrier sub-portion is a whole-layer structure, and an orthographic projection of the second barrier sub-portion on the substrate covers all of the first encapsulation portion, the second encapsulation portion and the first connection portion in the second transition sub-area.

In an embodiment of this disclosure, a width of the second barrier sub-portion is greater than or equal to twice a product of a width of the partition unit located in the second transition sub-area and a number of the partition units.

In an embodiment of this disclosure, a width of the first barrier layer is greater than or equal to twice a product of a width of the partition unit and a number of the partition units.

In an embodiment of this disclosure, the partition unit is a double-layer partition unit or a single-layer partition unit; the double-layer partition unit includes two stacked partition structures, and the single-layer partition unit includes a partition structure; the partition structure includes a first partition layer, a second partition layer and a third partition layer sequentially provided in a direction away from the substrate, and a width of the second partition layer is smaller than widths of the first partition layer and the third partition layer on both sides of and adjacent to the second partition layer.

In an embodiment of this disclosure, when the partition unit is the double-layer partition unit, the two partition structures include respectively a first partition structure and a second partition structure sequentially provided in a direction away from the substrate; the third partition layer of the first partition structure is reused as the first partition layer of the second partition structure, or the third partition layer of the first partition structure is stacked with the first partition layer of the second partition structure.

In an embodiment of this disclosure, a shape of a cross section, along a width direction of the partition unit, of the second partition layer of the partition structure is a regular trapezoid.

In an embodiment of this disclosure, a width of the third partition layer of the partition structure is smaller than a width of the first partition layer.

In an embodiment of this disclosure, a width of the first barrier portion corresponding to the double-layer partition unit is greater than a width of the first barrier portion corresponding to the single-layer partition unit.

In an embodiment of this disclosure, when the partition unit is the double-layer partition unit, the first barrier layer includes a first barrier sub-layer or a second barrier sub-layer; when the partition unit is the single-layer partition unit, the first barrier layer includes the first barrier sub-layer and the second barrier sub-layer; the first barrier sub-layer includes a plurality of sub-first barrier sub-portions, the second barrier sub-layer includes a plurality of sub-second barrier sub-portions, and the sub-second barrier sub-portions correspond one-to-one to the sub-first barrier sub-portions.

In an embodiment of this disclosure, the display panel further includes a driving circuit layer, the driving circuit layer is provided on a side of the substrate and located in the display area, and the driving circuit layer includes a first source-drain metal layer and a second source-drain metal layer; when the partition unit is the single-layer partition unit, the partition structure is provided in same layer and same material as the first source-drain metal layer or the second source-drain metal layer; and when the partition unit is the double-layer partition unit, the partition structure is provided in same layer and same material as the first source-drain metal layer and the second source-drain metal layer.

In an embodiment of this disclosure, the display panel further includes a touch layer group and a driving circuit layer, the driving circuit layer is provided on a side of the substrate, and the touch layer group is provided on a side of the driving circuit layer away from the substrate; the touch layer group includes a first touch control layer and a second touch control layer, the first barrier layer includes a first barrier sub-layer and/or a second barrier sub-layer, the first barrier sub-layer is provided in same layer and same material as one of the first touch control layer and the second touch control layer, and the second barrier sub-layer is provided in same layer and same material as another one of the first touch control layer and the second touch control layer.

In an embodiment of this disclosure, a first barrier segment is formed between two adjacent discontinuities of one discontinuous first barrier portion, and a length of the first barrier segment is greater than a length of the discontinuity.

In an embodiment of this disclosure, a distance between a partition unit located in the first transition sub-area and an edge of the opening is smaller than a distance between a partition unit located in the second transition sub-area and an edge of the display area.

In an embodiment of this disclosure, in a width direction of the first barrier portion, an orthographic projection of the first barrier portion on the encapsulation layer covers the first encapsulation portion, the first connection portion and a part of the second encapsulation portion.

In an embodiment of this disclosure, the second barrier layer covers the third encapsulation portion, the third connection portion and a part of the second encapsulation portion.

According to an aspect of this disclosure, a display panel is provided and has a main region, where the main region includes an opening area, a display area and a transition area connecting the display area and the opening area, the opening area is provided with an opening, and the display panel includes: a substrate, a barrier dam, at least two partition units, an encapsulation layer, and a first barrier layer. The barrier dam is provided on a side of the substrate and located in the transition area, where the transition area includes a first transition sub-area and a second transition sub-area, the first transition sub-area is located between an edge of the barrier dam and an edge of the opening, and the second transition sub-area is located between the edge of the barrier dam and an edge of the display area. The at least two partition units are provided in the first transition sub-area or the second transition sub-area, where the partition unit surrounds the opening, the partition unit includes at least one partition structure, the partition structure includes two partition layers, and a width of a partition layer away from the substrate is greater than a width of a partition layer close to the substrate. The encapsulation layer includes a first encapsulation portion, a second encapsulation portion and a first connection portion, where the first encapsulation portion is provided on a side of the partition unit away from the substrate, the second encapsulation portion is provided between two adjacent partition units, and the first connection portion is connected between the first encapsulation portion and the second encapsulation portion. The first barrier layer is provided on a side of the encapsulation layer away from the substrate, where the first barrier layer includes a second barrier structure, and an orthographic projection of the second barrier structure on the substrate covers all of the first encapsulation portion, the second encapsulation portion and the first connection portion located in the first transition sub-area and the second transition sub-area.

In an embodiment of this disclosure, the first transition sub-area and the second transition sub-area are each provided with at least two partition units, and the first barrier layer further includes a first barrier structure; the first barrier structure includes at least two first barrier sub-portions provided at an interval, the at least two first barrier sub-portions are provided in another one of the first transition sub-area and the second transition sub-area; in a width direction of the first barrier sub-portion, an orthographic projection of the first barrier sub-portion on the encapsulation layer at least overlaps with the first connection portion.

In an embodiment of this disclosure, the first barrier structure is provided in the first transition sub-area, and the second barrier structure is provided in the second transition sub-area.

According to yet another aspect of the present disclosure, a display device is provided, including the display panel according to any one aspect of the present disclosure.

The display panel disclosed in the present disclosure includes a partition unit, and a side of the partition unit away from the substrate is provided with an encapsulation layer, where the encapsulation layer includes a first connection portion, and a first barrier portion is provided on a side of the encapsulation layer away from the substrate. In the width direction of the first barrier portion, an orthographic projection of the first barrier portion on the encapsulation layer covers the first connection portion, thereby preventing water vapor from entering from the position where the first connection portion is covered. This can block and extend the path for water and oxygen to invade from the first connection portion, slow down or avoid corrosion of the luminescent material layer, improve the encapsulation effect of the display panel, and ensure the normal display of the display panel.

It is to be understood that the foregoing general description and the following detailed description are exemplary and explanatory only and are not restrictive of the present disclosure.

### BRIEF DESCRIPTION OF THE DRAWINGS

The accompanying drawings herein are incorporated into the specification and constitute a part of the specification, illustrate embodiments consistent with the present disclosure, and together with the specification are used to explain the principles of the present disclosure. However, the accompanying drawings described below are only some embodiments of the present disclosure, and for those skilled in the art, other accompanying drawings can be obtained based on these accompanying drawings without creative work.
FIG. 1 is a partial cross-sectional schematic diagram of a display panel when no first barrier layer is disposed on the encapsulation layer according to an embodiment of the present disclosure.
FIG. 2 is a schematic cross-sectional view of a display panel when the partition unit includes only a first partition unit according to an embodiment of the present disclosure.
FIG. 3 is a schematic plan view of a display panel according to an embodiment of the present disclosure.
FIG. 4 is a schematic cross-sectional view of a display panel when the partition unit includes a first partition unit and a second partition unit according to an embodiment of the present disclosure.
FIG. 5 is a schematic cross-sectional view of a display panel when the first barrier layer includes a first barrier sub-layer according to an embodiment of the present disclosure.
FIG. 6 is a schematic cross-sectional view of a display panel when the first barrier layer includes a first barrier sub-layer and a second barrier sub-layer according to an embodiment of the present disclosure.
FIG. 7 is a partial cross-sectional schematic diagram of a display panel when the partition unit is a first partition unit and a first barrier layer is disposed on the encapsulation layer according to an embodiment of the present disclosure.
FIG. 8 is a partial cross-sectional schematic diagram of a display panel when the partition unit is a second partition unit and a first barrier layer is disposed on the encapsulation layer according to an embodiment of the present disclosure.
FIG. 9 is another cross-sectional schematic diagram of a display panel when the first barrier layer includes a first barrier sub-layer according to an embodiment of the present disclosure.
FIG. 10 is another cross-sectional schematic diagram of a display panel when the first barrier layer includes a first barrier sub-layer and a second barrier sub-layer according to an embodiment of the present disclosure.
FIG. 11 is a partial cross-sectional schematic diagram of a display panel when a second barrier layer is disposed on the barrier dam according to an embodiment of the present disclosure.
FIG. 12 is a partial cross-sectional schematic diagram of a display panel when a second barrier layer is disposed on the barrier dam according to an embodiment of the present disclosure.
FIG. 13 is a partial plan view of a display panel when the partition unit includes two partition units according to an embodiment of the present disclosure.
FIG. 14 is a partial plan view of a display panel when the partition unit includes six partition units according to an embodiment of the present disclosure.
FIG. 15 is a partial plan view of a display panel when the first barrier layer includes only two discontinuous first barrier portions according to an embodiment of the present disclosure.
FIG. 16 is a partial plan view of a display panel when the first barrier layer includes only six discontinuous first barrier portions according to an embodiment of the present disclosure.
FIG. 17 is a partial plan view of a display panel when the first barrier layer includes two discontinuous first barrier portions and one closed first barrier portion according to an embodiment of the present disclosure.
FIG. 18 is another partial plan view of a display panel when the first barrier layer includes two discontinuous first barrier portions and one closed first barrier portion according to an embodiment of the present disclosure.
FIG. 19 is another partial plan view of a display panel when the first barrier layer includes two discontinuous first barrier portions and one closed first barrier portion according to an embodiment of the present disclosure.
FIG. 20 is another partial schematic plan view of a display panel when the first barrier layer includes two discontinuous first barrier portions and one closed first barrier portion according to an embodiment of the present disclosure.
FIG. 21 is a partial plan view of a display panel when the first barrier layer includes three discontinuous first barrier portions and three closed first barrier portions according to an embodiment of the present disclosure.
FIG. 22 is another partial plan view of a display panel when the first barrier layer includes three discontinuous first barrier portions and three closed first barrier portions according to an embodiment of the present disclosure.

In the drawings: 100-display area; 200-transition area, 2001-first transition sub-area, 2002-second transition sub-area, 300-opening, 400-peripheral area;
11-substrate, 12-buffer layer;
13-driving circuit layer, 131-active layer, 1321-first gate insulating layer, 1322-second gate insulating layer, 133 1-first gate, 1332-second gate, 134-interlayer dielectric layer, 135-first source, 136-drain, 137-protective layer, 138-second source;
14-planarization layer group, 141-first planarization layer, 142-second planarization layer;
15-pixel defining layer, 151-pixel opening;
16-light-emitting layer, 161-pixel electrode, 162-luminescent material layer, 163-common electrode;
17-encapsulation layer, 171-first inorganic encapsulation layer, 172-organic encapsulation layer, 173-second inorganic encapsulation layer, 1701-first encapsulation portion, 1702-second encapsulation portion, 1703-third encapsulation portion, 1704-first connection portion, 1705-second connection portion, 1706-third connection portion;
18-touch control layer, 181-first passivation layer, 182-first touch control layer, 1821-touch driving metal mesh, 1822-touch sensing metal mesh, 183-second passivation layer, 184-second touch control layer, 1823- first touch lead, 1824-second touch lead;
19-covering layer;
20-barrier dam;
201-first insulating layer, 202-second insulating layer, 203-third insulating layer;
21-partition unit, 211-first partition unit, 212-second partition unit, 213-first partition structure, 214-second partition structure, 215-first partition layer, 216-second partition layer, 217-third partition layer, 218-inner contour of partition unit, 219-outer contour of partition unit;
22-luminescent material portion, 221-first luminescent material portion, 222-second luminescent material portion, 223-third luminescent material portion;
23-common electrode portion, 231-first common electrode portion, 232-second common electrode portion, 233-third common electrode portion;
24-gate line, 241-first gate line, 242-second gate line;
251-first barrier sub-layer, 25ll-sub-first barrier sub-portion, 252-second barrier sub-layer, 2521-sub-second barrier sub-portion, 2531-first barrier sub-portion, 2532-second barrier sub-portion, 254-first barrier structure, 2541-discontinuous first barrier sub-portion, 2542-closed first barrier sub-portion, 255-second barrier structure, 2551-discontinuous second barrier sub-portion, 2552-closed second barrier sub-portion, 256-discontinuity, 257-inner contour of the first barrier layer, 258-outer contour of the first barrier layer;
26-second barrier layer, 261-inner contour of the second barrier layer, 262-outer contour of the second barrier layer.

### DETAILED DESCRIPTION

Example embodiments will now be described more fully with reference to the accompanying drawings. However, the example embodiments can be implemented in a variety of forms and should not be construed as limited to the embodiments set forth herein. Instead, these embodiments are provided so that the present disclosure will be comprehensive and complete and fully convey the concepts of the example embodiments to those skilled in the art. The same reference numerals in the drawings represent the same or similar structures, and thus their detailed description will be omitted. In addition, the drawings are only schematic illustrations of the present disclosure and are not necessarily drawn to scale.

Although relative terms such as "on/above" and "under/below" are used in this specification to describe the relative relationship of one component of the illustration to another component, these terms are used in this specification only for convenience, such as according to the orientation of the examples described in the drawings. It is understood that if the illustrated device is turned upside down, the component described as " on/above " will become the component " under/below ". When a structure is " on/above " other structures, it may mean that the structure is formed integrally on the other structure, or that the structure is "directly" disposed on the other structure, or that the structure is "indirectly" disposed on the other structure through another structure.

The terms "a", "an", "the", "said" and "at least one" are used to indicate the presence of one or more elements/components/etc.; the terms "including" and "having" are used to express an open-ended inclusive meaning and mean that additional elements/components/etc. may exist in addition to the listed elements/components/etc.; the terms "first", "second" and "third" etc. are used merely as labels and are not intended to limit the quantity of related objects.

In order to improve user experience, display devices are developing towards full screens. The perforated screen is a technology and a trend in the development of full screens that provides an opening on the display panel and provides the camera at the opening to increase the screen-to-body ratio of the display panel. To ensure the display effect, the cathode and the luminescent material layer are to be separated by a partition unit and encapsulated with an encapsulation layer.

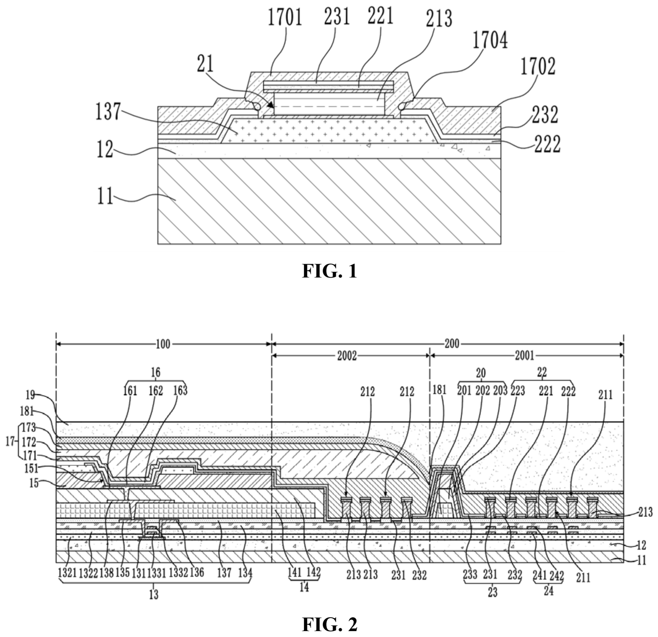

As shown in FIG. 1, the partition unit 21 is provided on a side of the substrate 11, the luminescent material layer 162 is provided on a side of the partition unit 21 away from the substrate 11, the cathode is provided on a side of the luminescent material layer 162 away from the substrate 11, and the luminescent material layer 162 and the cathode are separated by the partition unit 21. However, in order to ensure the partition effect of the partition unit 21, the side of the partition unit 21 close to the substrate 11 is undercut relative to the side thereof away from the substrate 11, which may easily lead to abnormal deposition morphology and cracks of the encapsulation layer 17 at the edge of the partition unit 21. The cracks become the intrusion path of water and oxygen, causing the encapsulation to fail. After the water and oxygen invade, the luminescent material layer 162 is corroded and fails, affecting the normal display. Therefore, how to slow down or avoid the corrosion of the luminescent material layer and improve the encapsulation effect of the display panel is the main improvement direction of the embodiments of the present disclosure.

In view of above, the embodiments of the present disclosure provide a display panel. As shown in FIG. 2 to FIG. 22, the display panel has a main region, the main region includes an opening area, a display area 100 and a transition area 200 connecting the display area 100 and the opening area, and the opening area is provided with an opening 300. The display panel includes a substrate 11, at least one partition unit 21, an encapsulation layer 17 and a first barrier layer. The at least one partition unit 21 is provided on a side of the substrate 11 and is located in the transition area 200. The partition unit 21 surrounds the opening 300, the partition unit 21 includes at least one partition structure, the partition structure includes two partition layers, and the width of the partition layer away from the substrate 11 is greater than the width of the partition layer close to the substrate 11. The encapsulation layer 17 includes a first encapsulation portion 1701, a second encapsulation portion 1702 and a first connection portion 1704; the first encapsulation portion 1701 is provided on the side of the partition unit 21 away from the substrate 11, the second encapsulation portion 1702 is provided between two adjacent partition units 21, the first connection portion 1704 is connected between the first encapsulation portion 1701 and the second encapsulation portion 1702, and the distance between the side of the first encapsulation portion 1701 away from the substrate 11 and the substrate 11 is greater than the distance between the side of the second encapsulation portion 1702 away from the substrate 11 and the substrate 11. The first barrier layer is provided on the side of the encapsulation layer 17 away from the substrate 11, and includes at least one first barrier portion. In the width direction of the first barrier portion, the orthographic projection of the first barrier portion on the encapsulation layer 17 covers the first connection portion 1704.

The encapsulation layer 17 is provided on the side of the partition unit 21 away from the substrate 11, and the encapsulation layer 17 includes a first connection portion 1704. A first barrier portion is provided on the side of the encapsulation layer 17 away from the substrate. In the width direction of the first barrier portion, the orthographic projection of the first barrier portion on the encapsulation layer 17 covers the first connection portion 1704, preventing water vapor from entering from the covered position of the first connection portion 1704, so as to block and prolong the path of water and oxygen invading from the first connection portion 1704, slow down or avoid corrosion of the luminescent material layer, improve the encapsulation effect of the display panel, and ensure the normal display of the display panel.

The display panel according to some embodiments of the present disclosure is described in detail below with reference to specific examples.

As shown in FIG. 2, the display panel may generally include a substrate 11, a driving circuit layer 13, a planarization layer group 14, and a light-emitting layer 16. The driving circuit layer 13 is disposed on a side of the substrate 11, the planarization layer group 14 is disposed on a side of the driving circuit layer 13 away from the substrate 11, and the light-emitting layer 16 is disposed on a side of the planarization layer group 14 away from the substrate 11. In addition, the display panel may further include a buffer layer 12, which is disposed between the substrate 11 and the driving circuit layer 13.

The substrate 11 may be a substrate of an inorganic material or an organic material. For example, in an embodiment of the present disclosure, the substrate 11 may be made of glass materials such as soda-lime glass, quartz glass, sapphire glass, or may be made of metal materials such as stainless steel, aluminum, and nickel.

In another embodiment of the present disclosure, the substrate 11 may also be a flexible substrate, for example, the substrate material may be polyimide (PI). The substrate 11 may also be a composite of multiple layers of materials. For example, in an embodiment of the present disclosure, the substrate 11 may include a bottom film layer (Bottom Film), a pressure-sensitive adhesive layer, a first polyimide layer, and a second polyimide layer stacked in sequence.

In the display area 100, the driving circuit layer 13 is provided with a driving circuit for driving the light-emitting unit. The driving circuit is located in the display area 100, and any one of the driving circuits may include a transistor, for example, a thin film transistor. The thin film transistor may be selected from a top-gate thin film transistor, a bottom-gate thin film transistor or a double-gate thin film transistor. Taking the top-gate thin film transistor as an example, the thin film transistor may include an active layer 131, a first gate electrode 1331, a second gate electrode 1332, a first gate insulating layer 1321, a second gate insulating layer 1322 and a source-drain electrode 136, wherein:

The active layer 131 is disposed on a side of the substrate 11. The material of the active layer 131 may be an amorphous silicon semiconductor material, a low-temperature polysilicon semiconductor material, a metal oxide semiconductor material, an organic semiconductor material or other types of semiconductor materials, so the thin film transistor may be an N-type thin film transistor or a P-type thin film transistor. The active layer 131 may include a channel region and two doped regions of different doping types located on both sides of the channel region.

The first gate insulating layer 1321 is disposed on a side of the active layer 131 away from the substrate 11, and the first gate insulating layer 1321 may cover the active layer 131 and the substrate 11. The first gate electrode 1331 is disposed on a side of the first gate insulating layer 1321 away from the substrate 11, and is directly opposite to the active layer 131, that is, the projection of the first gate electrode 1331 on the substrate 11 is located within the projection range of the active layer 131 on the substrate 11. For example, the projection of the first gate electrode 1331 on the substrate 11 coincides with the projection of the channel region of the active layer 131 on the substrate 11. The second gate insulating layer 1322 is disposed on a side of the first gate electrode 1331 away from the substrate 11, and the second gate insulating layer 1322 may cover the first gate electrode 1331 and the first gate insulating layer 1321. The second gate electrode 1332 is disposed on a side of the second gate insulating layer 1322 away from the substrate 11, and is directly opposite to the active layer 131. Materials of the first gate insulating layer 1321 and the second gate insulating layer 1322 are both insulating materials such as silicon oxide.

The thin film transistor may further include an interlayer dielectric layer 134, which is disposed on a side of the second gate electrode 1332 away from the substrate 11, and the interlayer dielectric layer 134 may cover the second gate electrode 1332 and the second gate insulating layer 1322, where the interlayer dielectric layer 134 is made of insulating material. The source-drain electrodes are disposed on a surface of the interlayer dielectric layer 134 away from the substrate 11, and the source-drain electrodes include a first source electrode 135 and a drain electrode 136, and the first source electrode 135 and the drain electrode 136 are connected to the active layer 131. For example, the first source electrode 135 and the drain electrode 136 are respectively connected to the two doped regions of the corresponding active layer 131 through vias.

A first planarization layer 141 is disposed on the side of the source-drain electrodes away from the substrate 11, and a surface of the first planarization layer 141 away from the substrate 11 is a plane. The source-drain electrodes may also include a second source electrode 138, and the second source electrode 138 is connected to the first source electrode 135. A second planarization layer 142 is provided on the side of the second source electrode 138 away from the substrate 11, and the second planarization layer 142 covers the second source electrode 138 and the first planarization layer 141. A protective layer 137 may also be provided on the side of the first source electrode 135 away from the substrate 11, and the protective layer 137 covers the first source electrode 135 and the drain electrode 136. The first planarization layer 141 covers the protective layer 137. It should be noted that the first source electrode 135 and the drain electrode 136 are located in the first source-drain metal layer of the driving circuit layer 13, and the second source electrode 138 is located in the second source-drain metal layer of the driving circuit layer 13.

The pixel defining layer 15 is disposed on a side of the first planarization layer 141 or the second planarization layer 142 away from the array substrate. The pixel defining layer 15 has a plurality of pixel openings 151, and the light-emitting layer 16 may include a plurality of light-emitting units, which are respectively disposed within different pixel openings 151. Each light-emitting unit may include a pixel electrode 161, a luminescent material layer 162, and a common electrode 163. The pixel electrode 161 is located on a surface of the first planarization layer 141 or the second planarization layer 142 away from the substrate 11, the luminescent material layer 162 is disposed on a surface of the pixel electrode 161 away from the substrate 11, and the common electrode 163 is disposed on a surface of the luminescent material layer 162 away from the substrate 11. The luminescent material layer 162 may be driven to emit light through the pixel electrode 161 and the common electrode 163 to display an image.

The pixel electrode 161 is connected to the first source electrode 135 or the second source electrode 138. The pixel defining layer 15 is provided on the side of the pixel electrode 161 away from the substrate 11. When the thin film transistor only includes the first source electrode 135, the pixel electrode 161 is connected to the first source electrode 135, and the pixel defining layer 15 covers the pixel electrode 161 and the first planarization layer 141. When the thin film transistor also includes the second source electrode 138, the pixel electrode 161 is connected to the second source electrode 138, and the pixel defining layer 15 covers the pixel electrode 161 and the second planarization layer 142.

The common electrode 163 can be used as a cathode, and the pixel electrode 161 can be used as an anode. The luminescent material layer 162 can be driven to emit light by applying a signal to the pixel electrode 161, while the specific light-emitting principle will not be elaborated here. The luminescent material layer 162 may include an electroluminescent organic luminescent material and can be formed by a process such as evaporation. For example, the luminescent material layer 162 may include a hole injection layer, a hole transport layer, a light generating layer, an electron transport layer, and an electron injection layer stacked in sequence on the layer of pixel electrode 161. It should be noted that the luminescent material layer 162 may include a red luminescent material layer, a green luminescent material layer and a blue luminescent material layer according to different luminescent colors.

In addition, the display panel of the present disclosure may further include an encapsulation layer 17, which is disposed on a side of the light-emitting layer 16 away from the substrate 11, thereby encapsulating the light-emitting layer 16 to prevent corrosion by water and oxygen. The encapsulation layer 17 may be a single-layer or multi-layer structure, and the material of the encapsulation layer 17 may include organic or inorganic materials, which are not specifically limited here.

In some embodiments, the encapsulation layer 17 may include a first inorganic encapsulation layer 171, an organic encapsulation layer 172 and a second inorganic encapsulation layer 173. The first inorganic encapsulation layer 171 is provided on the side of the light-emitting layer 16 away from the substrate 11, the organic encapsulation layer 172 is provided on the side of the first inorganic encapsulation layer 171 away from the substrate 11, and the second inorganic encapsulation layer 173 is provided on the side of the organic encapsulation layer 172 away from the substrate 11.

The display panel also includes a touch control layer 18, and the touch control layer 18 may be in the mode of mutual capacitive touch control, where the touch control layer 18 includes a first touch control layer 182 and a second touch control layer 184. The first touch control layer 182 can be a metal mesh layer (Metal Mesh, MM), and the second touch control layer 184 can be a bridge metal layer (Bridge Metal, BM). The first touch control layer 182 can also be a bridge metal layer (Bridge Metal, BM), and the second touch control layer 184 can be a metal mesh layer (Metal Mesh, MM).

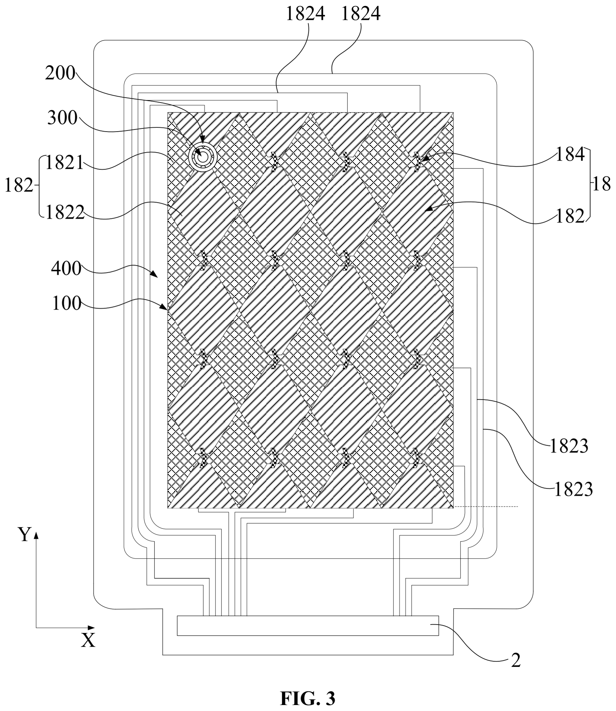

The following description assumes that the first touch control layer 182 is a metal mesh layer (MM) and the second touch control layer 184 is a bridge metal layer (BM). As shown in FIG. 3, the first touch control layer 182 is located in the display area 100, and can be divided into a touch driving metal mesh 1821 and a touch sensing metal mesh 1822 in the horizontal and vertical directions, where one of the touch sensing metal mesh 1822 and the touch driving metal mesh 1821 is connected internally, and the other is connected through a second touch control layer 184. The first passivation layer 181 is provided on the side of the encapsulation layer 17 away from the substrate 1, the first touch control layer 182 is provided on the side of the first passivation layer 181 away from the substrate 11, the second passivation layer 183 is provided on the side of the first touch control layer 182 away from the substrate 11, the second touch control layer 184 is provided on the side of the second passivation layer 183 away from the substrate 11, and a covering layer 19 is provided on the side of the second touch control layer 184 away from the substrate 11.

The touch control layer 18 also includes touch leads, which may include: a first touch lead 1823 disposed in the same layer as the first touch control layer 182, and a second touch lead 1824 disposed in the same layer as the second touch control layer 184. The first touch lead 1823 is electrically connected to the touch driving metal mesh 1821, and the second touch lead 1824 is electrically connected to the touch sensing metal mesh 1822. The first touch lead 1823 and the second touch lead 1824 are located in the peripheral area 400 and are bound to the touch driving chip. It should be noted that the peripheral area 400 is connected to the edge of the display area.

By providing the touch lead as a double-layer wiring including the first touch lead 1823 and the second touch lead 1824, it is possible to load the touch signal to the first touch control layer 182 through one layer of the wiring after the other layer of wiring is partially broken, thereby effectively solving the problem that the single-layer wiring breakage easily leads to touch failure. In addition, compared with the design of the single-layer wiring, the double-layer wiring can also reduce the resistance value of the touch lead. In specific implementation, the first touch lead 1823 and the second touch lead 1824 can be electrically connected through a through via.

The main region also includes a transition area 200, which is located between the edge of the opening 300 and the edge of the display area 100. Due to the flow of liquid organic encapsulation material, the liquid organic encapsulation material is prone to overflow. In order to prevent the organic encapsulation material from overflowing, a barrier dam 20 is provided in the transition area 200. The barrier dam 20 is provided on the side of the protective layer 137 away from the substrate 11. The barrier dam 20 is provided around the opening 300, and the barrier dam 20 plays a blocking role. The cross-sectional shape of the barrier dam 20 can be rectangular or trapezoidal, and the barrier dam 20 has at least a side edge close to the display area 100 being provided as an inclined surface, which is not limited here.

The stacked pattern of the barrier dam 20 includes an insulating layer group, which is provided with the same material as one or more layers of the first planarization layer 141, the second planarization layer 142, and the pixel defining layer 15. As shown in FIG. 2, the stacked pattern of the barrier dam 20 includes a first insulating layer 201, which is provided with the same layer and material as the first planarization layer 141. A second insulating layer 202 can also be provided on the first insulating layer 201, and the second insulating layer 202 is provided with the same layer and same material as the second planarization layer 142. A third insulating layer 203 can also be provided on the second insulating layer 202, and the third insulating layer 203 is provided with the same layer and same material as the pixel defining layer 15.

The transition area 200 includes a first transition sub-area 2001 and a second transition sub-area 2002. The first transition sub-area 2001 is located between the edge of the barrier dam 20 and the edge of the opening 300, and the second transition sub-area 2002 is located between the edge of the barrier dam 20 and the edge of the display area 100. That is, the second transition sub-area 2002 is provided close to the display area 100, and the first transition sub-area 2001 is provided farther away from the display area 100 than the second transition sub-area 2002.

The first gate insulating layer 1321 and the second gate insulating layer 1322 extend from the display area 100 to the first transition sub-area 2001 and the second transition sub-area 2002. The display panel further includes gate lines 24, which include a first gate line 241 and a second gate line 242. The first gate line 241 is provided on the side of the first gate insulating layer 1321 in the first transition sub-area 2001 away from the substrate 11, and the second gate line 242 is provided on the side of the second gate insulating layer 1322 away from the substrate 11. In other words, the first gate line 241 and the first gate electrode 1331 are provided in the same layer and the same material, and the second gate line 242 and the second gate electrode 1332 are provided in the same layer and the same material.

The protective layer 137 extends from the display area 100 to the first transition sub-area 2001 and the second transition sub-area 2002. The protective layer 137 in the first transition sub-area 2001 and the protective layer 137 in the second transition sub-area 2002 are both provided with a partition unit 21 on the side away from the substrate 11, including a first partition unit 211 in the first transition sub-area 2001 is, and a second partition unit 212 in the second transition sub-area 2002. The first transition sub-area 2001 and the second transition sub-area 2002 are respectively provided with at least one partition unit 21. In order to further improve the partition effect, the first transition sub-area 2001 and the second transition sub-area 2002 are both provided with at least two partition units 21. For example, the first transition sub-area 2001 is provided with three first partition units 211, and the second transition sub-area 2002 is provided with three second partition units 212.

The width of at least part of the partition unit 21 is smaller than the width of the side away from the substrate 11. Specifically, the partition unit 21 can be provided as a structure that is wider at both ends and narrower in the middle, or as an inverted trapezoidal structure in which the width gradually decreases from the end away from the substrate 11 to the end close to the substrate 11, or to other structures that are concave (undercut) in the height direction. For example, the partition unit 21 can be provided as a Ti-Al-Ti structure.

The luminescent material layer 162 extends to the transition area 200 and is located at the side of the partition unit 21 away from the substrate 11. The luminescent material layer 162 is partitioned by the partition unit 21 to form a plurality of luminescent material portions 22. The common electrode 163 located on the side of the luminescent material layer 162 away from the substrate 11 is also partitioned by the partition unit 21 to form a plurality of common electrode portions 23. The luminescent material portions 22 are divided into a first luminescent material portion(s) 221 and a second luminescent material portion(s) 222. The first luminescent material portion 221 is disposed on a side of the partition unit 21 away from the substrate 11, and the second luminescent material portion 222 is disposed between two adjacent partition units 21. Similarly, the common electrode portions 23 are divided into a first common electrode portion(s) 231 and a second common electrode portion(s) 232. The first common electrode portion 231 is disposed on a side of the partition unit 21 away from the substrate 11, and the second common electrode portion 232 is disposed between two adjacent partition units 21.

The distance between the side of the second common electrode portion 232 in the first transition sub-area 2001 away from the substrate 11 and the side of the first common electrode portion 231 away from the substrate 11 is a first distance, and the distance between the side of the second common electrode portion 232 in the second transition sub-area 2002 away from the substrate 11 and the side of the first common electrode portion 231 away from the substrate 11 is a second distance.

In order to ensure that the side of the first common electrode portion 231 in the first transition sub-area 2001 away from the substrate 11 and the side of the first common electrode portion 231 in the second transition sub-area 200 away from the substrate 11 are basically on the same plane, a plurality of openings are provided on the protective layer 137 between two adjacent second partition units 212, and the second common electrode portion 232 in the second transition sub-area 2002 is provided within the opening, which is equivalent to the second common electrode portion 232 being provided on the side of the second gate insulating layer 1322 away from the substrate 11. The first partition unit 211 is provided on the side of the protective layer 137 away from the substrate 11. It should be noted that the width of the opening is smaller than the distance between two adjacent first partition units 211, so as to ensure that the protective layer 137 between the adjacent openings can effectively support the first partition unit 211.

It can be understood that the second distance is equal to the sum of the thickness of the protective layer 137 and the height of the second partition unit 212, and the first distance is equal to the height of the first partition unit 211. Since the height of the second partition unit 212 is equal to the height of the first partition unit 211, the difference between the second distance and the first distance is the thickness of the protective layer 137. The thickness of the protective layer 137 is substantially equal to the sum of the thickness of the first gate line 241 and that of the second gate line 242, so that the side of the first common electrode portion 231 in the first transition sub-area 2001 away from the substrate 11 and the side of the first common electrode portion 232 in the second transition sub-area 2002 away from the substrate 11 can be ensured to be substantially in the same plane.

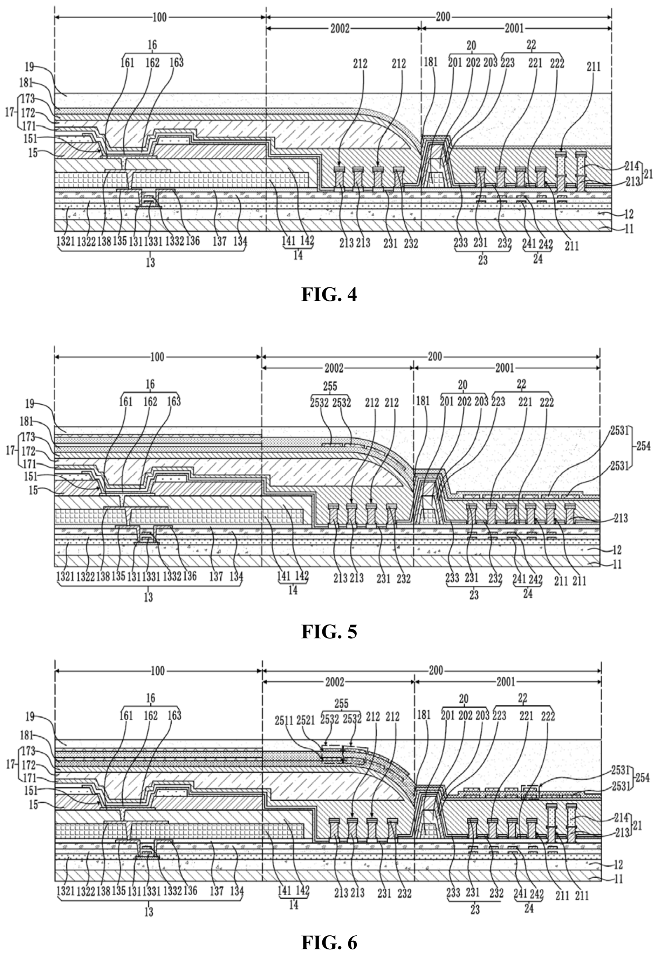

As shown in FIG. 3 and FIG. 4, the partition unit 21 is a single-layer partition unit 21 or a double-layer partition unit 21. The display panel may include only a single-layer partition unit 21, or may include both a double-layer partition unit 21 and a single-layer partition unit 21. The double-layer partition unit 21 includes a first partition structure 213 and a second partition structure 214, and the single-layer partition unit 21 includes one of the first partition structure 213 and the second partition structure 214. The first partition structure 213 is provided in the same layer and same material as the first source-drain metal layer, and the second partition structure 214 is provided in the same layer and same material as the second source-drain metal layer.

The double-layer partition unit 21 includes both the first partition structure 213 and the second partition structure 214. On the one hand, the thickness of the double-layer partition unit 21 is greater than that of the single-layer partition unit 21, thereby achieving a better partition effect. On the other hand, the first partition structure 213 and the second partition structure 214 both have an anchoring structure, which makes the display panel stronger in the thickness direction and easier to resist film peeling caused by film stress problems during cutting.

The encapsulation layer 17 is provided on the side of the partition unit 21 away from the substrate 11, and the encapsulation layer 17 in the transition area 200 includes a first encapsulation portion 1701, a second encapsulation portion 1702 and a first connection portion 1704. The first encapsulation portion 1701 is provided on the side of the first common electrode portion 231 away from the substrate 11, the second encapsulation portion 1702 is provided on the side of the second common electrode portion 232 away from the substrate 11, and the first connection portion 1704 is connected between the first encapsulation portion 1701 and the second encapsulation portion 1702. Because there is a step difference between the second common electrode portion 232 and the first common electrode portion 231, the distance between the side of the first encapsulation portion 1701 away from the substrate 11 and the substrate 11 is greater than the distance between the side of the second encapsulation portion 1702 away from the substrate 11 and the substrate 11, so cracks may easily be formed at the connection between the first encapsulation portion 1701 and the second encapsulation portion 1702, that is, at the first connection portion 1704.

A first barrier layer is provided on a side of the encapsulation layer 17 away from the substrate 11, the first barrier layer includes first barrier portions, and the number of the first barrier portions may be equal to the number of the partition units 21. The orthographic projection of the first barrier portion on the substrate 11 overlaps with the orthographic projection of the first connection portion 1704 on the substrate 11. The contour shape of the first barrier layer is similar to the shape of the opening 300.

As shown in FIG. 5 and FIG. 6, the first barrier layer includes a first barrier structure 254 and a second barrier structure 255. The first barrier structure 254 may include a first barrier sub-portion 2531 discontinuously provided, and the orthographic projection of the first barrier sub-portion 2531 on the substrate 11 overlaps with the first connection portion 1704 in the first transition sub-area 2001. The second barrier structure 255 may include a second barrier sub-portion 2532 discontinuously provided, and the orthographic projection of the second barrier sub-portion 2532 on the substrate 11 overlaps with the first connection portion 1704 in the second transition sub-area 2002. The first barrier sub-portion 2531 and the second barrier sub-portion 2532 are attached to the side of the encapsulation layer 17 away from the substrate 11, and at least a part of the second barrier sub-portion 2532 gradually bends toward the side close to the substrate 11 along the direction close to the opening 300.

The side of the second partition unit 212 away from the substrate 11 is generally covered with an organic encapsulation layer 172, while the side of the first partition unit 211 away from the substrate 11 is not covered with the organic encapsulation layer 172. When the organic encapsulation layer 172 is formed, if the inkjet printing process fluctuates, the side of the second partition unit 212 away from the substrate 11 may be covered with only a very thin organic encapsulation layer 172, or may not be covered with the organic encapsulation layer 172 at all.

In the transition area between the area uniformly covered by the organic encapsulation layer 172 and the area without being covered by the organic encapsulation layer 172, the distance between two adjacent first connection portions 1704 is relatively large. In other words, the width of the first encapsulation portion 1701 in the transition area is greater than the width of the first encapsulation portion 1701 in the area covered by the organic encapsulation layer 172. The area covered by the organic encapsulation layer 172 is relatively thick, the area not covered by the organic encapsulation layer 172 is relatively thin, and the transition area refers to the arc surface area where the organic encapsulation layer 172 changes from thick to thin.

Therefore, in order to ensure that the second barrier sub-portion 2532 covers the second partition unit 212, the width of the second barrier sub-portion 2532 is to increased. The ratio of the width of the second barrier sub-portion 2532 to the width of the second partition unit 212 is greater than the ratio of the width of the first barrier sub-portion 2531 to the width of the first partition unit 211. Specifically, the ratio of the width of the first barrier sub-portion 2531 to the width of the first partition unit 211 is 1.5-2, and the ratio of the width of the second barrier sub-portion 2532 to the width of the second partition unit 212 is 2-3.

In other implementations, the second barrier sub-portion 2532 may be provided as a whole-layer structure, that is, the orthographic projection of the second barrier sub-portion 2532 on the substrate 11 covers all of the first encapsulation portion 1701, the second encapsulation portion 1702 and the first connection portion 1704 in the second transition sub-area 2002. It should be further explained that the width of the second barrier sub-portion 2532 is greater than or equal to twice the product of the width of the partition unit 21 located in the second transition sub-area 2002 and the number of the partition units 21, that is, the width of the second barrier sub-portion 2532 is greater than or equal to twice the product of the width of the second partition unit 212 and the number of the second partition units 212.

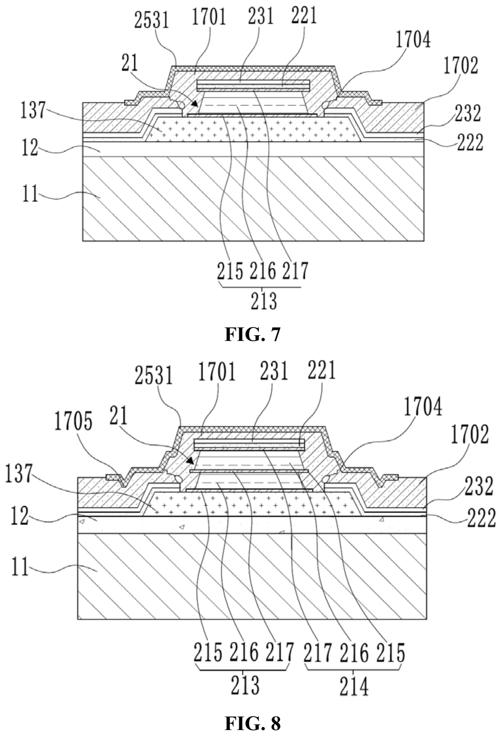

As shown in FIG. 7 and FIG. 8, the partition structure includes a first partition layer 215, a second partition layer 216, and a third partition layer 217, which are sequentially provided in a direction away from the substrate 11, and the width of the second partition layer 216 is smaller than the widths of the first partition layer 215 and the third partition layer 217 on both sides thereof and adjacent thereto. The cross-section of the second partition layer 216 of the partition structure along the width direction of the partition unit is a regular trapezoid. The width of the third partition layer 217 of the partition structure is smaller than the width of the first partition layer 215.

When the partition unit is a double-layer partition unit, the double-layer partition unit includes a first partition structure 213 and a second partition structure 214 which are sequentially provided in a direction away from the substrate, and the third partition layer 217 of the first partition structure is reused as the first partition layer 215 of the second partition structure. Alternatively, the third partition layer 217 of the first partition structure can also be stacked with the first partition layer 215 of the second partition structure. The cross-section shape, along the width direction of the partition unit, of the second partition layers 216 of the first partition structure 213 and of the second partition structure 214 is a regular trapezoid. In the direction away from the substrate, the width of the first partition layer 215 of the first partition structure 213, the width of the third partition layer 217 (the first partition layer 215 of the second partition structure 214), and the width of the third partition layer 217 of the second partition structure 214 gradually decrease.

Taking the first transition sub-area in FIG. 6 as an example, the single-layer partition unit 21 can just meet the partition height requirement, while the double-layer partition unit 21 is much larger than this value, which can fully guarantee the partition effect. The second encapsulation portions 1702 on both sides of the single-layer partition unit 21 are relatively flat, so the first barrier sub-portion 2531 covering the second encapsulation portion 1702 is relatively flat. In comparison, the first barrier sub-portion 2531 on both sides of the double-layer partition unit 21 is not flat, and a V-shaped depression is formed on the second encapsulation portion 1702 on both sides of the first encapsulation portion 1701. The location of the depression is the second connection portion 1705, which is easy to become a stress concentration point, resulting in cracks and forming a water vapor channel.

When the first barrier sub-portion 2531 covers part of the second encapsulation portion 1702, it may further be required that the first barrier sub-portion 2531 on the side of the double-layer partition unit 21 away from the substrate 11 can completely cover the first connection portion 1704, so the width of the first barrier sub-portion 2531 corresponding to the double-layer partition unit 21 is greater than the width of the first barrier sub-portion 2531 corresponding to the single-layer partition unit 21. The ratio of the width of the first barrier sub-portion 2531 corresponding to the double-layer partition unit 21 to the width of the double-layer partition unit 21 is 2-3, and the ratio of the width of the first barrier sub-portion 2531 corresponding to the single-layer partition unit 21 to the width of the single-layer partition unit 21 is 1.5-2. After the first barrier sub-portion 2531 covers the surface of the second encapsulation portion 1702, the first barrier sub-portion 2531 forms a V-shaped depression, completely covering the second connection portion 1705, thereby effectively blocking water and oxygen.

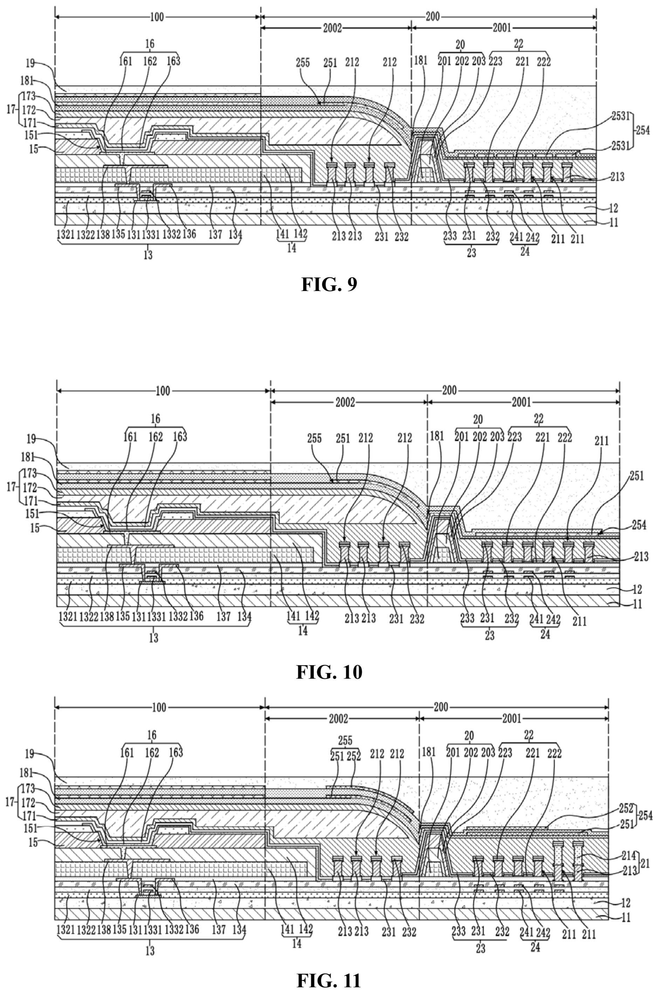

As shown in FIG. 9, the second barrier structure 255 can be provided as a whole-layer structure, and the orthographic projection of the second barrier structure 255 on the substrate 11 covers all of the first encapsulation portion 1701, the second encapsulation portion 1702 and the first connection portion 1704 located in the first transition sub-area 2001 and the second transition sub-area 2002. The first barrier structure 254 is provided to include at least two first barrier sub-portions 2531, which are provided in the other of the first transition sub-area 2001 and the second transition sub-area 2002. In the width direction of the first barrier sub-portion 2531, the orthographic projection of the first barrier sub-portion 2531 on the encapsulation layer 17 at least overlaps with the first connection portion 1704. Further, the first barrier structure 254 is provided in the first transition sub-area 2001, and the second barrier structure 255 is provided in the second transition sub-area 2002.

As shown in FIG. 10 and FIG. 11, in other possible implementations, the first barrier structure 254 can also be provided as a whole-layer structure, and the second barrier structure 255 can be provided as a whole-layer structure, the orthographic projection of the first barrier structure 254 on the substrate 11 covers all of the first encapsulation portion, the second encapsulation portion and the first connection portion 1704 in the first transition sub-area 2001, and the orthographic projection of the second barrier structure 255 on the substrate 11 covers all of the first encapsulation portion, the second encapsulation portion and the first connection portions 1704 in the second transition sub-area 2002.

The width of the first barrier layer is greater than or equal to twice the product of the width of the partition unit 21 and the number of the partition units 21. It should be noted here that the width of the first barrier layer refers to the width of the orthographic projection of the first barrier layer on the substrate 11.

When the first barrier layer includes a plurality of first barrier portions, the width of the first barrier layer refers to the sum of the widths of the plurality of first barrier portions and the widths of the gaps between adjacent first barrier portions. When the first barrier layer includes a first barrier structure 254 or a second barrier structure 255 of an integral structure, the width of the first barrier layer refers to the width of the first barrier structure 254 or the width of the second barrier structure 255. When the first barrier layer includes a first barrier structure 254 and a second barrier structure 255 of an integral structure, the width of the first barrier layer refers to the sum of the width of the first barrier structure 254 and the width of the second barrier structure 255.

When the partition unit 21 is a single-layer partition unit 21, the single-layer partition unit 21 has a small height difference, and the partition effect is relatively poor. The first barrier layer includes the first barrier sub-layer 251 and the second barrier sub-layer 252, thereby better blocking water and oxygen. When the partition unit 21 is a double-layer partition unit 21, the double-layer partition unit 21 has a large height difference, the partition effect is relatively good, and the first barrier layer can only include the first barrier sub-layer 251 or the second barrier sub-layer 252.

The first barrier layer includes a first barrier sub-layer 251 and/or a second barrier sub-layer 252. The first barrier sub-layer 251 is formed in the same layer and the same material as one of the first touch control layer and the second touch control layer, and the second barrier sub-layer 252 is formed in the same layer and the same material as the other of the first touch control layer and the second touch control layer. It should be noted that the materials of the first touch control layer and the second touch control layer include but are not limited to Al, Ag, Cu, Ti-Al-Ti, and ITO.

In FIG. 6, the first barrier sub-layer 251 may include a plurality of sub-first barrier sub-portions 2511, the second barrier sub-layer 252 includes a plurality of sub-second barrier sub-portions 2521, and the sub-second barrier sub-portions 2521 correspond one to one with the sub-first barrier sub-portions 2511. That is, the orthographic projection of the sub-second barrier sub-portion 2521 on the substrate 11 coincides with the orthographic projection of the sub-first barrier sub-portion 2511 on the substrate 11. It can be understood that, as shown in FIG. 11, when the sub-second barrier sub-portion and the sub-first barrier sub-portion are a whole-layer structure, the sub-second barrier sub-portion and the sub-first barrier sub-portion also correspond to each other.

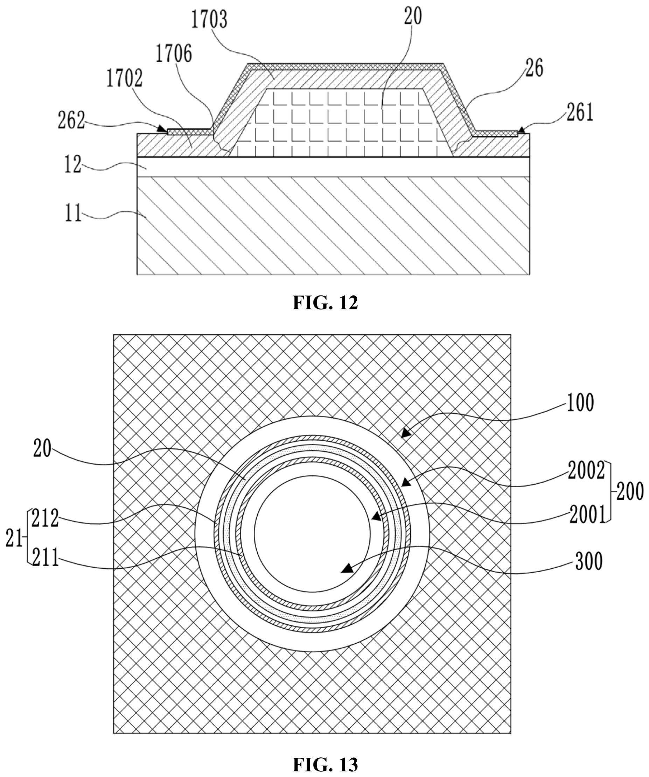

A third luminescent material portion 223, a third common electrode portion 233, a third encapsulation portion 1703, a first passivation layer 181 and a second passivation layer 183 are sequentially disposed on a side of the barrier dam 20 away from the substrate 11. As shown in FIG. 12, the third encapsulation portion 1703 is provided on the side of the barrier dam 20 away from the substrate 11. When the angle between the inclined surface of the barrier dam 20 and the substrate 11 is greater than 50°, it is easy to form the third connection portion 1706 at the second connection between the third encapsulation portion 1703 and the second encapsulation portion 1702. The second barrier layer 26 is also provided on the side of the encapsulation layer 17 away from the substrate 11. The orthographic projection of the second barrier layer 26 on the substrate 11 covers the third connection portion 1706. The second barrier layer has an inner contour and an outer contour. The shape of inner contour 261 of the second barrier layer and the shape of outer contour 262 of the second barrier layer are both similar to the shape of the opening 300.

Referring to FIG. 7, FIG. 8 and FIG. 12, in order to ensure the barrier effect of the first barrier layer and the second barrier layer 26, the first barrier sub-portion 2531 covers the first encapsulation portion 1701, the first connection portion 1704 and a part of the second encapsulation portion 1702 located at the edge of the first encapsulation portion 1701. The second barrier layer 26 covers the third encapsulation portion 1703, the third connection portion 1706 and a part of the second encapsulation portion 1702 located at the edge of the third encapsulation portion 1703.

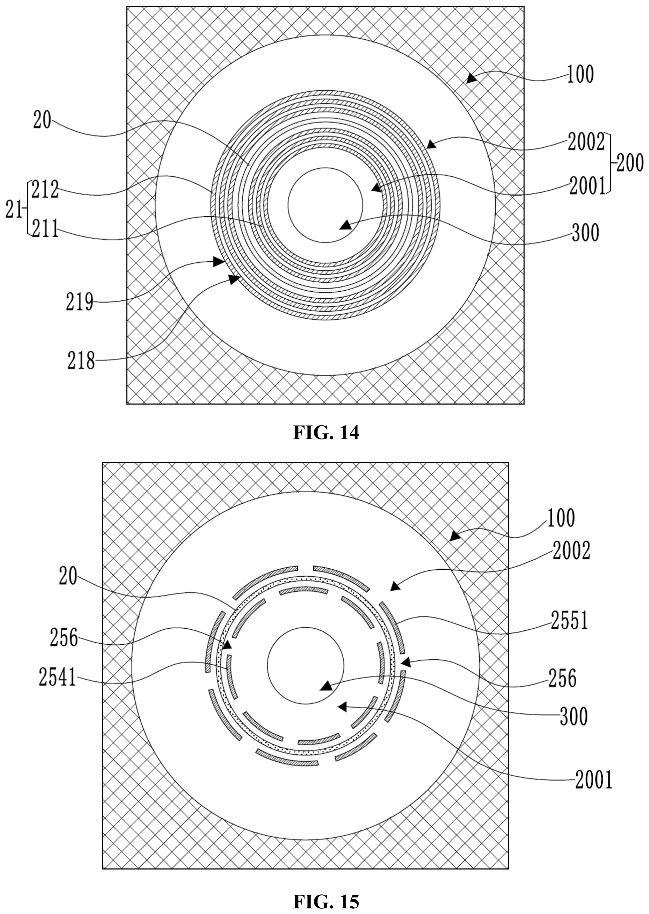

As shown in FIG. 13 and FIG. 14, the partition unit 21 extends in a direction parallel to the substrate 11, and the orthographic projection of the partition unit 21 on the substrate 11 is a continuous and uninterrupted closed figure, and the partition unit 21 has no signal connection. The contour shape of the partition unit 21 is similar to the shape of the opening 300. For example, when the shape of the opening 300 is circular, the shape of the partition unit 21 is a circular ring. The number of partition units can be two as shown in FIG. 13, or six as shown in FIG. 14. However, the number of partition units is at least greater than two.

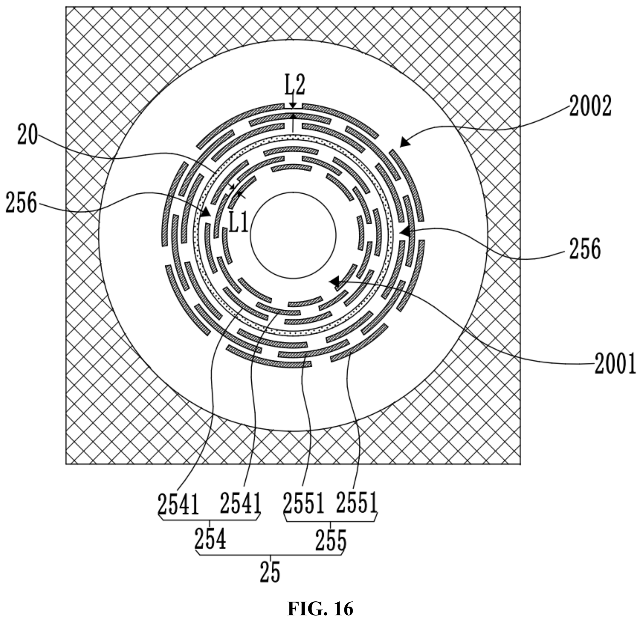

As shown in FIG. 15 and FIG. 16, the first barrier layer includes a discontinuous first barrier sub-portion 2541 and a discontinuous second barrier sub-portion 2551. The orthographic projection of the discontinuous first barrier sub-portion 2541 on the substrate 11 overlaps with the orthographic projection of the first connection portion corresponding to the first partition unit 211 on the substrate 11, and the orthographic projection of the discontinuous second barrier sub-portion 2551 on the substrate overlaps with the orthographic projection of the first connection portion corresponding to the second partition unit 212 on the substrate.

The number of the discontinuous first barrier sub-portions 2541 is the same as the number of the first partition units 211, and the number of the discontinuous second barrier sub-portions 2551 is the same as the number of the second partition units 212. When the partition unit includes one first partition unit 211 and one second partition unit 212, the first barrier layer includes the discontinuous first barrier sub-portion 2541 and the discontinuous second barrier sub-portion 2551. When the barrier unit includes three first barrier units 211 and three second barrier units 212, the first barrier layer includes three discontinuous first barrier sub-portions 2541 and three discontinuous second barrier sub-portions 2551.

The discontinuous first barrier sub-portion 2541 is provided with a discontinuity 256, and the discontinuous second barrier sub-portion 2551 is provided with a discontinuity 256. Along the extension direction of the discontinuous first barrier sub-portion 2541, a first barrier segment is formed between two adjacent discontinuities 256. The length of the first barrier segment of the same discontinuous first barrier sub-portion 2541 and the same discontinuous second barrier sub-portion 2551 is greater than the length of the discontinuity 256.

As shown in FIG. 15, when the first barrier layer includes a discontinuous first barrier sub-portion 2541 and a discontinuous second barrier sub-portion 2551, the discontinuities 256 corresponding to two adjacent discontinuous first barrier sub-portions 2541 and the discontinuities 256 corresponding to two adjacent discontinuous second barrier sub-portions 2551 are staggered along the extension direction away from the edge of the opening 300. As shown in FIG. 16, when the first barrier layer includes a plurality of discontinuous first barrier sub-portions 2541, the discontinuities 256 corresponding to two adjacent discontinuous first barrier sub-portions 2541 are staggered along the extension direction away from the edge of the opening 300; and when the first barrier layer includes a plurality of discontinuous second barrier sub-portions 2551, the discontinuities 256 corresponding to two adjacent discontinuous second barrier sub-portions 2551 are staggered.

The first barrier segment covers part of the first connection portion 1704, preventing water vapor from entering from the covered position of the first connection portion 1704, so that water vapor can only pass through the discontinuity 256 of the discontinuous first barrier portion. The discontinuity 256 corresponding to two adjacent discontinuous first barrier portions are staggered along the extension direction of the partition unit 21, thereby extending the path for water and oxygen to invade from the first connection portion 1704. The length of a single first barrier segment is short, thereby reducing the accumulation of static electricity during the formation of the first barrier portion and reducing the risk of electrostatic discharge damaging the display panel.

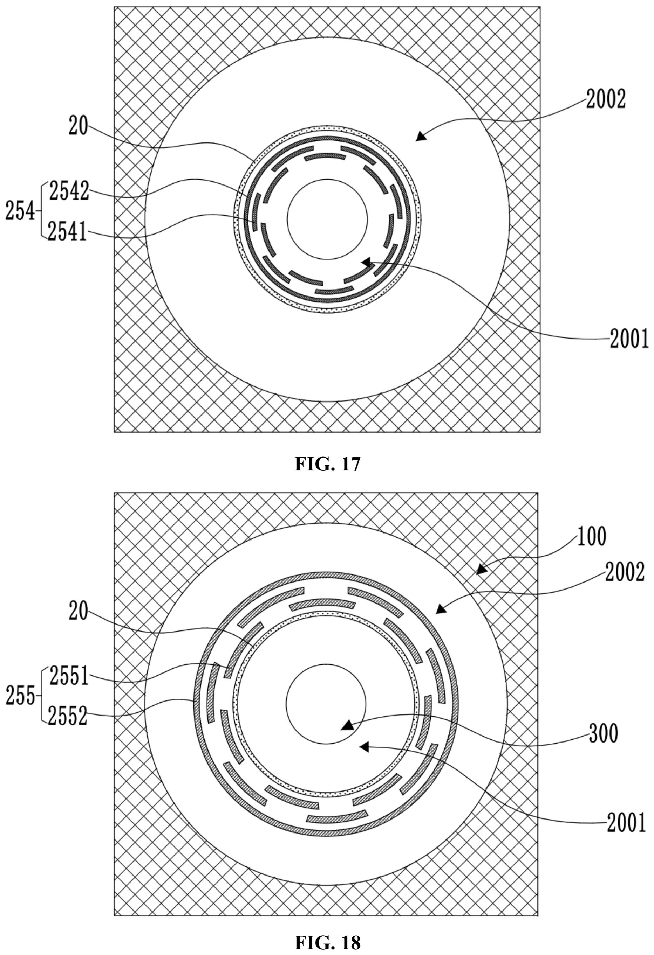

As shown in FIG. 17 to FIG. 21, based on FIG. 15 and FIG. 16, the first barrier layer further includes a closed first barrier portion, which is provided as a continuous whole, and the orthographic projection of the closed first barrier portion on the substrate 11 covers the orthographic projection of the partition unit 21 on the substrate 11. The closed first barrier portion completely blocks water vapor from entering the interior of the display panel from its corresponding first connection portion 1704.

As shown in FIG. 17 to FIG. 20, the first barrier layer may include a closed first barrier portion and two discontinuous first barrier portions. The two discontinuous first barrier portions can be provided on both sides of the closed first barrier portion. Alternatively, the closed first barrier portion can be provided close to the opening 300; and the two discontinuous first barrier portions are provided far away from the opening 300, that is, close to the display area 100. In order to better prevent water vapor from entering, the closed first barrier portion is generally provided far away from the opening 300, and the two discontinuous first barrier portions are provided close to the opening 300. After the entry path of water vapor is extended by the two discontinuous first barrier portions, the amount of water vapor is reduced to a certain extent, and then blocked by the closed first barrier portion, so the water vapor blocking effect is better.

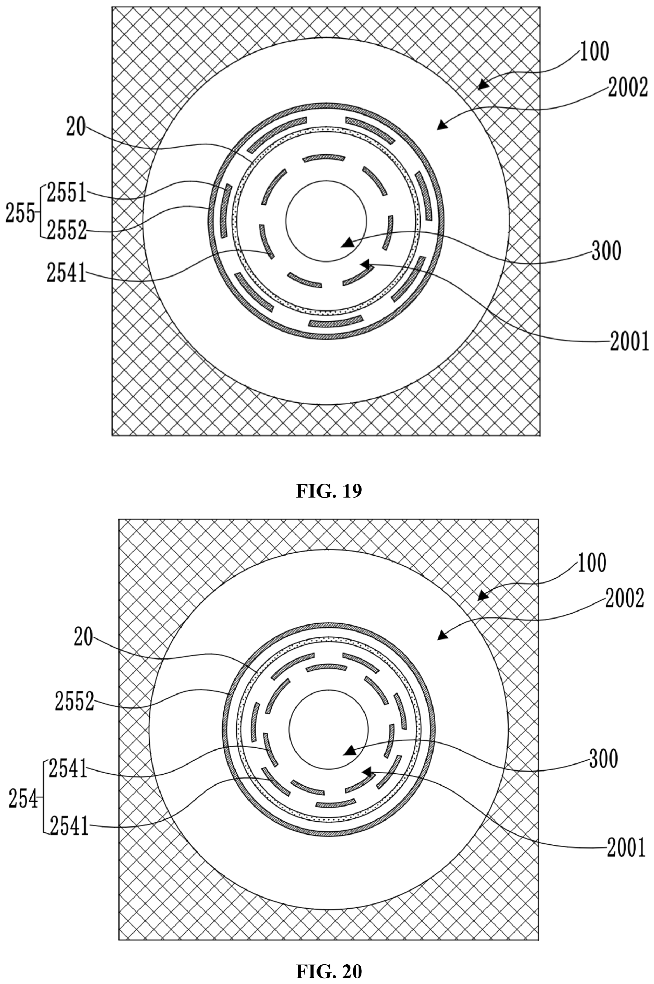

The closed first barrier portion and the two discontinuous first barrier portions can be both provided in the first transition sub-area 2001 or the second transition sub-area 2002. As shown in FIG. 17, the first barrier layer includes two discontinuous first barrier sub-portions 2541 and one closed first barrier sub-portion 2542. As shown in FIG. 18, the first barrier layer includes two discontinuous second barrier sub-portions 2551 and one closed second barrier sub-portion 2552. As shown in FIG. 19, one discontinuous first barrier portion can be provided in the first transition sub-area 2001, and another discontinuous first barrier portion and the closed first barrier portion can be provided in the second transition sub-area 2002. The first barrier layer includes one discontinuous first barrier sub-portion 2541, one discontinuous second barrier sub-portion 2551 and one closed second barrier sub-portion 2552. As shown in FIG. 20, two discontinuous first barrier portions may be provided in the first transition sub-area 2001, and the closed first barrier portion may be provided in the second transition sub-area 2002; that is, the first barrier layer includes two discontinuous first barrier sub-portions 2541 and one closed second barrier sub-portion 2552.

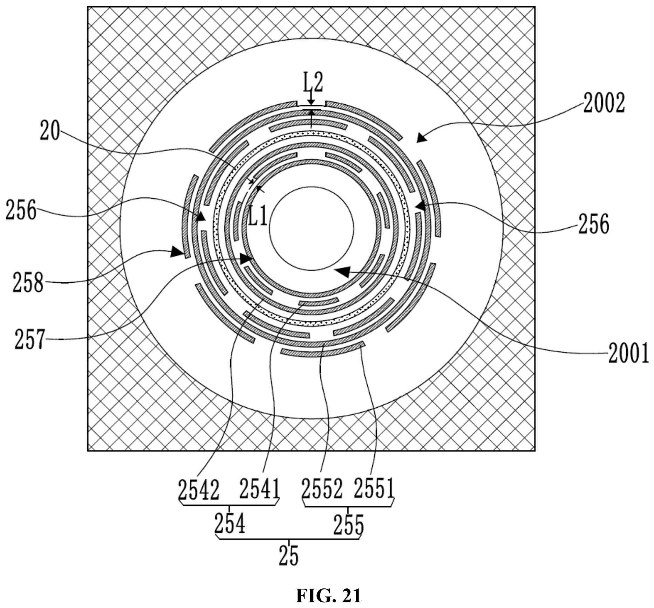

As shown in FIG. 21, the first barrier layer includes a plurality of discontinuous first barrier portions and a plurality of closed first barrier portions, and the plurality of closed first barrier portions and the plurality of discontinuous first barrier portions are alternately arranged in a direction away from the opening 300. The plurality of closed first barrier portions and the plurality of discontinuous first barrier portions alternately block the water vapor path and extend the water vapor path, thereby better preventing water vapor from entering the interior of the display panel.

The first barrier layer includes at least one closed first barrier portion and at least two discontinuous first barrier portions. The closed first barrier portion is provided as a continuous whole, and the orthographic projection of the closed first barrier portion on the substrate covers the orthographic projection of the partition unit on the substrate. The discontinuous first barrier portion is provided with a discontinuity, and along the direction away from the opening 300, at least part of the discontinuity of the discontinuous first barrier portion is located on the same straight line along the width direction perpendicular to the partition unit 21.

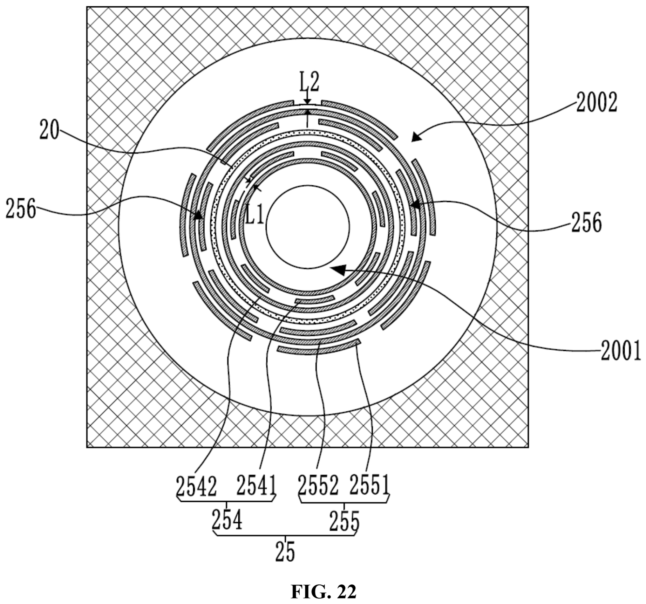

As shown in FIG. 22, the first barrier layer includes three closed first barrier portions and three discontinuous first barrier portions, which are staggeredly distributed in a direction away from the opening 300, and a part of the first barrier layer closest to the opening 300 can be provided as a closed first barrier portion. The discontinuities of the three discontinuous first barrier portions are all located on the same straight line along a width direction perpendicular to the partition unit 21, thereby reducing the risk of electrostatic discharge damaging the display panel while blocking the water vapor path.

The discontinuous first barrier portions include a discontinuous first barrier sub-portion 2541 and a discontinuous second barrier sub-portion 2551. The distance between adjacent first barrier segments of the discontinuous first barrier sub-portion 2541 is smaller than the distance between adjacent first barrier segments of the discontinuous second barrier sub-portion 2551. More water vapor enters the first connection portion 1704 close to the opening 300, so the width of the discontinuity 256 of the discontinuous first barrier sub-portion 2541 close to the opening 300 is smaller. As the amount of water vapor gradually decreases away from the opening 300, even if the width of the discontinuity 256 of the discontinuous first barrier sub-portion 2541 far from the opening 300 is larger, water vapor can well be prevented from entering.

The length of the first barrier segment of different discontinuous first barrier portions gradually increases in the direction away from the opening. Specifically, the length of the first barrier segment of different discontinuous first barrier sub-portions 2541 and the length of the first barrier segment of the discontinuous second barrier sub-portions 2551 both gradually increase in the direction away from the opening, and the length of the first barrier segment of any discontinuous first barrier sub-portion 2541 is less than the length of the first barrier segment of any discontinuous second barrier sub-portion 2551.

The distance L2 between adjacent second barrier sub-portions is smaller than the distance L1 between adjacent first barrier sub-portions. The distribution density of the first barrier sub-portions close to the display area 100 is greater than the distribution density of the first barrier sub-portions far from the display area 100. The greater the density of the discontinuous first barrier, the longer the path for water vapor to enter; and the greater the density of the closed first barrier, the more times water vapor is blocked. Therefore, no matter the structure in FIG. 15 and FIG. 16 or the structure in FIG. 17 to FIG. 21 is adopted for the first barrier layer, water vapor can well be prevented from entering the interior of the display panel from the encapsulation layer 17.

In addition, the distance between the partition unit 21 located in the first transition sub-area 2001 and the edge of the opening 300 is smaller than the distance between the partition unit 21 located in the second transition sub-area 2002 and the edge of the display area 100. That is, the distance between the first partition unit 211 and the edge of the opening 300 is smaller than the distance between the second partition unit 212 and the edge of the display area 100. The distance between the second partition unit 212 and the edge of the display area 100 is larger, thereby preventing the first barrier layer of the display area 100 from being short-circuited with the touch control layer 18. The distance between the first partition unit 211 and the edge of the opening 300 is smaller, so that the first barrier layer can protect the devices in the opening 300.

It should be noted that the partition unit 21 and the first barrier layer both have an inner contour and an outer contour, the shape of inner contour 218 of the partition unit and the shape of outer contour 219 of the partition unit, and the shape of inner contour 257 of the first barrier layer and the shape of outer contour 258 the first barrier layer, are all similar to the shape of the opening 300.

The present disclosure also provides a display device, which may include the display panel mentioned in the foregoing embodiments of the present disclosure. The specific structure and beneficial effects of the display panel have been described in detail above, which will not be repeated here.

It should be noted that, in addition to the display panel, the display device also includes other necessary components and components, such as a housing, a circuit board, a power cord, and the like. Those skilled in the art may make corresponding supplements according to the specific usage requirements of the display device, which will not be elaborated here.

The display device can be a traditional electronic device, such as a mobile phone, a computer, a television, and a camcorder; or it can be an emerging wearable device, such as a virtual reality device and an augmented reality device, which will not be enumerated here.

It should be noted that the foregoing embodiments are interoperable and can be combined with each other to form other schemes, and the scheme of the present disclosure is not limited to the schemes described in the foregoing embodiments. After considering the specification and practicing the invention disclosed herein, those skilled in the art will easily think of other embodiments of the present disclosure. This application is intended to cover any modification, use or adaptive change of the present disclosure, which follows the general principles of the present disclosure and includes common knowledge or customary technical means in the art that are not disclosed in the present disclosure. The description and embodiments are to be regarded as exemplary only, and the true scope and spirit of the present disclosure are indicated by the appended claims.

## Claims

1. A display panel having a main region, wherein the main region comprises an opening area, a display area and a transition area connecting the display area and the opening area, the opening area is provided with an opening, and the display panel comprises:
a substrate;
at least one partition unit, provided on a side of the substrate and located in the transition area, wherein the partition unit surrounds the opening, the partition unit comprises at least one partition structure, the partition structure comprises two partition layers, and a width of a partition layer away from the substrate is greater than a width of a partition layer close to the substrate;
an encapsulation layer, comprising a first encapsulation portion, a second encapsulation portion and a first connection portion, wherein the first encapsulation portion is provided on a side of the partition unit away from the substrate, the second encapsulation portion is provided between two adjacent partition units, the first connection portion is connected between the first encapsulation portion and the second encapsulation portion, and a distance between the substrate and a surface of the first encapsulation portion away from the substrate is greater than a distance between the substrate and a surface of the second encapsulation portion away from the substrate; and
a first barrier layer, provided on a side of the encapsulation layer away from the substrate, wherein the first barrier layer comprises at least one first barrier portion; and in a width direction of the first barrier portion, an orthographic projection of the first barrier portion on the encapsulation layer covers the first connection portion.

2. The display panel according to claim 1, wherein the at least one first barrier portion comprises at least two discontinuous first barrier portions, the discontinuous first barrier portions are provided with discontinuities, and the discontinuities of two adjacent discontinuous first barrier portions are staggered with each other along an extension direction of the partition unit.

3. The display panel according to claim 1, wherein the at least one first barrier portion comprises at least two closed first barrier portions, the closed first barrier portion is provided as a continuous whole, and an orthographic projection of the closed first barrier portion on the substrate covers an orthographic projection of the partition unit on the substrate.

4. The display panel according to claim 1, further comprising a barrier dam, wherein the barrier dam is provided on a side of the substrate and located in the transition area; the encapsulation layer further comprises a third encapsulation portion and a third connection portion, the third encapsulation portion is provided on a side of the barrier dam away from the substrate, the third connection portion is connected between the third encapsulation portion and the second encapsulation portion; the display panel further comprises a second barrier layer, and in a width direction of the second barrier layer, an orthographic projection of the second barrier layer on the encapsulation layer covers the third connection portion.

5. The display panel according to claim 2 or 3, further comprising a barrier dam, wherein the barrier dam is provided on a side of the substrate and located in the transition area; the transition area comprises a first transition sub-area and a second transition sub-area, the first transition sub-area is located between an edge of the barrier dam and an edge of the opening, and the second transition sub-area is located between the edge of the barrier dam and an edge of the display area; the first transition sub-area is provided with at least one partition unit, and the second transition sub-area is provided with at least one partition unit; the first barrier portion comprises a first barrier sub-portion and a second barrier sub-portion, an orthographic projection of the first barrier sub-portion on the encapsulation layer covers a part of the second encapsulation portion and the first encapsulation portion in the first transition sub-area, and an orthographic projection of the second barrier sub-portion on the encapsulation layer covers a part of the second encapsulation portion and the first encapsulation portion in the second transition sub-area.

6. The display panel according to claim 4, wherein the partition unit, the first barrier layer and the second barrier layer all have an inner contour and an outer contour, a shape of the inner contour of the partition unit and/or the outer contour of the partition unit, a shape of the inner contour of the first barrier layer and/or the outer contour of the first barrier layer, and a shape of the inner contour of the second barrier layer and/or the outer contour of the second barrier layer are all similar to a shape of the opening.

7. The display panel according to claim 5, wherein the first transition sub-area and the second transition sub-area are each provided with at least two partition units, the first transition sub-area is provided with at least two first barrier sub-portions provided at an interval, and the second transition sub-area is provided with at least two second barrier sub-portions provided at an interval.

8. The display panel according to claim 2, wherein the first barrier layer further comprises at least one closed first barrier portion, the closed first barrier portion is provided as a continuous whole, and an orthographic projection of the closed first barrier portion on the substrate covers an orthographic projection of the partition unit on the substrate.

9. The display panel according to claim 8, wherein the first barrier layer comprises a plurality of discontinuous first barrier portions and a plurality of closed first barrier portions, and the plurality of closed first barrier portions and the plurality of discontinuous first barrier portions are alternately arranged in sequence along an extension direction away from an edge of the opening.

10. The display panel according to claim 1, wherein the at least one first barrier portion comprises at least one closed first barrier portion and at least two discontinuous first barrier portions, the closed first barrier portion is provided as a continuous whole, an orthographic projection of the closed first barrier portion on the substrate covers an orthographic projection of the partition unit on the substrate; the discontinuous first barrier portions are provided with discontinuities, and at least part of the discontinuities are located on a same straight line along a direction perpendicular to a width of the partition unit.

11. The display panel according to claim 2, wherein a first barrier segment is formed between two adjacent discontinuities of one discontinuous first barrier portion, and lengths of first barrier segments of different discontinuous first barrier portions gradually increase in a direction away from the opening.

12. The display panel according to claim 7, wherein the first barrier sub-portion comprises a discontinuous first barrier sub-portion, the second barrier sub-portion comprises a discontinuous second barrier sub-portion, and a length of a discontinuity of the discontinuous first barrier sub-portion is smaller than a length of a discontinuity of the discontinuous second barrier sub-portion.

13. The display panel according to claim 7, wherein a distance between adjacent second barrier sub-portions is smaller than a distance between adjacent first barrier sub-portions.

14. The display panel according to claim 5, wherein a ratio of a width of the second barrier sub-portion to a width of the partition unit is greater than a ratio of a width of the first barrier sub-portion to the width of the partition unit.

15. The display panel according to claim 7, wherein the first barrier sub-portion and the second barrier sub-portion are attached to a side of the encapsulation layer away from the substrate, and an arrangement track of at least part of the second barrier sub-portion is gradually bent along a direction close to the opening toward the substrate.

16. The display panel according to claim 5, wherein the second barrier sub-portion is a whole-layer structure, and an orthographic projection of the second barrier sub-portion on the substrate covers all of the first encapsulation portion, the second encapsulation portion and the first connection portion in the second transition sub-area.

17. The display panel according to claim 16, wherein a width of the second barrier sub-portion is greater than or equal to twice a product of a width of the partition unit located in the second transition sub-area and a number of the partition units.

18. The display panel according to claim 1, wherein a width of the first barrier layer is greater than or equal to twice a product of a width of the partition unit and a number of the partition units.

19. The display panel according to claim 1, wherein the partition unit is a double-layer partition unit or a single-layer partition unit; the double-layer partition unit comprises two stacked partition structures, and the single-layer partition unit comprises a partition structure; the partition structure comprises a first partition layer, a second partition layer and a third partition layer sequentially provided in a direction away from the substrate, and a width of the second partition layer is smaller than widths of the first partition layer and the third partition layer on both sides of and adjacent to the second partition layer.

20. The display panel according to claim 19, wherein, when the partition unit is the double-layer partition unit, the two partition structures include respectively a first partition structure and a second partition structure sequentially provided in a direction away from the substrate; the third partition layer of the first partition structure is reused as the first partition layer of the second partition structure, or the third partition layer of the first partition structure is stacked with the first partition layer of the second partition structure.

21. The display panel according to claim 19 or 20, wherein a shape of a cross section, along a width direction of the partition unit, of the second partition layer of the partition structure is a regular trapezoid.

22. The display panel according to claim 21, wherein a width of the third partition layer of the partition structure is smaller than a width of the first partition layer.

23. The display panel according to claim 19, wherein a width of the first barrier portion corresponding to the double-layer partition unit is greater than a width of the first barrier portion corresponding to the single-layer partition unit.

24. The display panel according to claim 19, wherein, when the partition unit is the double-layer partition unit, the first barrier layer comprises a first barrier sub-layer or a second barrier sub-layer; when the partition unit is the single-layer partition unit, the first barrier layer comprises the first barrier sub-layer and the second barrier sub-layer; the first barrier sub-layer comprises a plurality of sub-first barrier sub-portions, the second barrier sub-layer comprises a plurality of sub-second barrier sub-portions, and the sub-second barrier sub-portions correspond one-to-one to the sub-first barrier sub-portions.

25. The display panel according to claim 19, wherein the display panel further comprises a driving circuit layer, the driving circuit layer is provided on a side of the substrate and located in the display area, and the driving circuit layer comprises a first source-drain metal layer and a second source-drain metal layer; when the partition unit is the single-layer partition unit, the partition structure is provided in same layer and same material as the first source-drain metal layer or the second source-drain metal layer; and when the partition unit is the double-layer partition unit, the partition structure is provided in same layer and same material as the first source-drain metal layer and the second source-drain metal layer.

26. The display panel according to claim 19, wherein the display panel further comprises a touch layer group and a driving circuit layer, the driving circuit layer is provided on a side of the substrate, and the touch layer group is provided on a side of the driving circuit layer away from the substrate; the touch layer group comprises a first touch control layer and a second touch control layer, the first barrier layer comprises a first barrier sub-layer and/or a second barrier sub-layer, the first barrier sub-layer is provided in same layer and same material as one of the first touch control layer and the second touch control layer, and the second barrier sub-layer is provided in same layer and same material as another one of the first touch control layer and the second touch control layer.

27. The display panel according to claim 2, wherein a first barrier segment is formed between two adjacent discontinuities of one discontinuous first barrier portion, and a length of the first barrier segment is greater than a length of the discontinuity.

28. The display panel according to claim 5, wherein a distance between a partition unit located in the first transition sub-area and an edge of the opening is smaller than a distance between a partition unit located in the second transition sub-area and an edge of the display area.

29. The display panel according to claim 1, wherein, in a width direction of the first barrier portion, an orthographic projection of the first barrier portion on the encapsulation layer covers the first encapsulation portion, the first connection portion and a part of the second encapsulation portion.

30. The display panel according to claim 4, wherein the second barrier layer covers the third encapsulation portion, the third connection portion and a part of the second encapsulation portion.

31. A display panel having a main region, wherein the main region comprises an opening area, a display area and a transition area connecting the display area and the opening area, the opening area is provided with an opening, and the display panel comprises:
a substrate;
a barrier dam, provided on a side of the substrate and located in the transition area, wherein the transition area comprises a first transition sub-area and a second transition sub-area, the first transition sub-area is located between an edge of the barrier dam and an edge of the opening, and the second transition sub-area is located between the edge of the barrier dam and an edge of the display area;
at least two partition units, provided in the first transition sub-area or the second transition sub-area, wherein the partition unit surrounds the opening, the partition unit comprises at least one partition structure, the partition structure comprises two partition layers, and a width of a partition layer away from the substrate is greater than a width of a partition layer close to the substrate;
an encapsulation layer, comprising a first encapsulation portion, a second encapsulation portion and a first connection portion, wherein the first encapsulation portion is provided on a side of the partition unit away from the substrate, the second encapsulation portion is provided between two adjacent partition units, and the first connection portion is connected between the first encapsulation portion and the second encapsulation portion; and
a first barrier layer, provided on a side of the encapsulation layer away from the substrate, wherein the first barrier layer comprises a second barrier structure, and an orthographic projection of the second barrier structure on the substrate covers all of the first encapsulation portion, the second encapsulation portion and the first connection portion located in the first transition sub-area and the second transition sub-area.

32. The display panel according to claim 31, wherein the first transition sub-area and the second transition sub-area are each provided with at least two partition units, and the first barrier layer further comprises a first barrier structure; the first barrier structure comprises at least two first barrier sub-portions provided at an interval, the at least two first barrier sub-portions are provided in another one of the first transition sub-area and the second transition sub-area; in a width direction of the first barrier sub-portion, an orthographic projection of the first barrier sub-portion on the encapsulation layer at least overlaps with the first connection portion.

33. The display panel according to claim 32, wherein the first barrier structure is provided in the first transition sub-area, and the second barrier structure is provided in the second transition sub-area.

34. A display device, comprising the display panel according to any one of claims 1 to 33.
